# FASCICULE DE BREVET EUROPEEN

(11) **EP 1 049 813 B1**
(45) Date de publication et mention de la délivrance du brevet: **23.08.2006**
(21) Numéro de dépôt: 99956143.4
(22) Date de dépôt: 25.11.1999
(51) Int. Cl.: C23C 16/46, C30B 25/10

(54) **REACTEUR ET PROCEDE POUR DEPOT CHIMIQUE EN PHASE VAPEUR**
CVD-REAKTOR UND VERFAHREN ZUM BETRIEB DESSELBEN
CVD REACTOR AND PROCESS

(30) Priorité: 25.11.1998 FR 9814831; 07.05.1999 FR 9905840
(43) Date de publication de la demande: 08.11.2000
(73) Titulaire: CENTRE NATIONAL DE LA RECHERCHE SCIENTIFIQUE, 75016 Paris Cédex (FR)
(72) Inventeur: LEYCURAS, André, 06560 Valbonne (FR)
(74) Mandataire: Texier, Christian
(86) Numéro de dépôt international: PCT/FR1999/002909
(87) Numéro de publication internationale: WO 2000/031317

(56) Documents cités:
- EP-A- 0 792 956
- US-A- 5 108 540
- US-A- 5 759 263
- US-A- 5 769 942
- PATENT ABSTRACTS OF JAPAN vol. 007, no. 251 (E-209), 8 novembre 1983 (1983-11-08) & JP 58 139424 A (HITACHI SEISAKUSHO KK), 18 août 1983 (1983-08-18)
- PATENT ABSTRACTS OF JAPAN vol. 017, no. 340 (E-1389), 28 juin 1993 (1993-06-28) & JP 05 047674 A (FUJITSU LTD), 26 février 1993 (1993-02-26)
- PATENT ABSTRACTS OF JAPAN vol. 004, no. 130 (E-025), 12 septembre 1980 (1980-09-12) & JP 55 083226 A (FUJITSU LTD), 23 juin 1980 (1980-06-23)
- PATENT ABSTRACTS OF JAPAN vol. 096, no. 009, 30 septembre 1996 (1996-09-30) & JP 08 120451 A (TOKAI CARBON CO LTD), 14 mai 1996 (1996-05-14)

## Description

L'invention concerne le domaine de la fabrication de couches de matériaux sur un substrat. Plus précisément, il s'agit d'un procédé de dépôt chimique en phase vapeur, de matériaux sur un substrat, pour faire des couches, éventuellement mono-cristallines. L'invention concerne aussi un réacteur pour la mise en oeuvre de ce procédé.

On connaît déjà de nombreux dispositifs pour déposer des couches sur des substrats par les méthodes dites CVD (acronyme de l'expression anglo-saxonne « Chemical Vapour Deposition ») ou MOCVD (acronyme de l'expression anglo-saxonne « Metal Organic Chemical Vapour Deposition », c'est à dire quand un ou plusieurs précurseurs sont présents sous la forme de composés organo-métalliques).

Pour obtenir des couches de matériau d'une qualité suffisante pour les applications auxquelles elles sont destinées, il est nécessaire de chauffer le substrat sur lequel elles sont déposées. Généralement, le chauffage du substrat est réalisé par conduction thermique entre celui-ci et un porte-substrat, parfois aussi appelé suscepteur, qui est lui-même chauffé par induction, par effet Joule ou par un rayonnement généré par des lampes.

Par exemple, grâce à la demande internationale PCT WO96/23912, on connaît un réacteur pour réaliser la croissance épitaxiale de carbure de silicium par une méthode CVD. Ce réacteur comprend une enceinte externe et un conduit interne. Les gaz porteurs et les gaz de croissance circulent dans le conduit interne mais peuvent aussi communiquer avec l'espace compris entre le conduit interne et l'enceinte externe. Dans un tel réacteur, le substrat sur lequel doit être effectué le dépôt est placé dans le flux gazeux, dans le conduit interne. Ce substrat est chauffé par des moyens de chauffage comprenant un suscepteur et un bobinage. Le suscepteur est placé sous la zone du conduit interne où se trouve le substrat pendant le dépôt. Le suscepteur est à proximité du conduit interne ou en contact avec lui. Le suscepteur peut même constituer une partie de la paroi du conduit, au niveau de cette zone. Le bobinage génère un champ radiofréquence dans la région du suscepteur, de manière à ce que le suscepteur, sous l'excitation de ce champ radiofréquence produise de la chaleur.

On connaît également par le document Patent Abstract of Japan, vol. 7, n° 251, un réacteur de dépôt en phase vapeur, de couches d'un matériau d'un substrat s'étendant principalement dans un plan, comprenant des premiers et deuxièmes moyens de chauffage constitués de lampes et situés à l'extérieur d'un conduit de quartz, de part et d'autre du substrat qui se trouve lui, dans le conduit.

Cependant, d'une part, le bilan énergétique de ce mode de chauffage, comme de celui par rayonnement, est particulièrement mauvais à cause d'un mauvais couplage entre générateur (bobines ou lampes) et suscepteur.

Parfois, le bilan énergétique est encore dégradé lorsque l'on utilise un tube en quartz dans lequel est confiné le porte-substrat, pour canaliser les gaz, et que le tube est à double paroi pour permettre la circulation d'eau pour le refroidissement du tube. En effet, ceci limite encore le couplage entre la bobine d'induction et le suscepteur.

Ainsi, pour effectuer des dépôts à l'aide de ce type de réacteur, à des températures qui sont parfois supérieures à 1500°C, il est nécessaire de les alimenter avec une puissance souvent supérieure à 10 kilowatts, pour un réacteur d'une capacité d'un substrat de 50 mm de diamètre. De plus, le chauffage par induction exige des investissements coûteux du fait de cette technologie et du surdimensionnement nécessaire lorsque l'on utilise des générateurs hautes fréquences.

D'autre part, le bilan énergétique peut être aussi mauvais, quel que soit le mode de chauffage, à cause d'un mauvais couplage thermique entre le porte-substrat et le substrat. En effet, lorsque le substrat est simplement posé sur le porte-substrat, l'échange thermique s'effectue mal par conduction solide ; très peu, voire quasiment pas, par conduction gazeuse, surtout si la pression des gaz est très faible ; et très peu aussi par rayonnement si le substrat est transparent dans le domaine du rayonnement du suscepteur. Pour palier ces problèmes, des solutions existent telles que le collage du substrat sur le porte substrat ou le dépôt d'une couche absorbante à l'arriére du substrat Mais ces solutions nécessitent des étapes de préparation supplémentaires non souhaitables ; les matériaux de collage ou de dépôt en face arrière peuvent polluer les réacteurs de dépôt et les couches réalisées dans ces réacteurs; parfois même, ces solutions sont inefficaces pour les chauffages à haute température.

Le document US 2873222 divulgue un procédé et un dispositif de chauffage d'une tranche semiconductrice pour son dopage dans un tube entouré de bobines. On connaît par le document JP 58 139424 A une technique de dépôt utilisant des moyens de chauffage résistifs situés à l'intérieur du conduit de dépôt.

Le document JP 58 139 424 A divulgue un procédé selon le préambule de la revendication 1 et un réacteur selon le préambule de la revendication 5.

Un but de l'invention est de fournir un procédé de dépôt de matériaux en couche sur substrat qui soit plus économique notamment grâce à un meilleur bilan énergétique que ce que permettent les dispositifs de l'art antérieur.

Ce but est atteint grâce à l'invention qui, dans l'un de ses aspects, est un procédé selon la revendication 1.

Ainsi, grâce au procédé selon l'invention, les deux faces principales d'un substrat globalement plan sont chauffées. Le chauffage de la face de dépôt par les deuxièmes moyens de chauffage permet de compenser les pertes thermiques radiatives de cette face. De ce fait, la température souhaitée pour cette face est atteinte en chauffant moins la face opposée avec les premiers moyens de chauffage. On peut, de cette manière, consommer une plus faible puissance dans les premiers moyens de chauffage. Au total, cette puissance économisée n'est pas compensée par la consommation des deuxièmes moyens de chauffage. Le procédé de dépôt selon l'invention est donc plus économique que les procédés de dépôt déjà connus.

En outre, comme le substrat est placé dans un conduit balayé par les composés gazeux nécessaires au dépôt, le conduit étant interposé entre le substrat et les premiers et deuxièmes moyens de chauffage, le substrat est chauffé par le rayonnement de la chaleur du conduit, qui lui même est chauffé, par les moyens de chauffage situés à proximité de ce dernier, mais également par les gaz qui sont eux-mêmes chauffés par le conduit. Ceci améliore encore le couplage entre les moyens de chauffage et le substrat. De plus, le conduit canalise les flux gazeux en limitant les turbulences susceptibles de perturber la croissance des couches de matériau sur leur substrat.

Avantageusement, le procédé selon l'invention comprend une étape consistant à disposer au moins un écran thermique autour des premiers et deuxièmes moyens de chauffage.

Avantageusement encore, le procédé selon l'invention comprend une étape consistant à générer un gradient de température perpendiculairement au plan du substrat et orienté dans un premier sens. Le procédé selon l'invention peut même comprendre une étape consistant à inverser le sens du gradient de température par rapport au premier sens. Le fait de pouvoir choisir et modifier le sens du gradient est une possibilité très intéressante du procédé selon l'invention.

Selon un autre aspect, l'invention est un réacteur selon la revendication 5. Avantageusement le réacteur selon l'invention comprend au moins un écran thermique autour des premiers et deuxièmes moyens de chauffage.

D'autres aspects, avantages et buts de l'invention apparaîtront à la lecture de la description détaillée qui suit. L'invention sera aussi mieux comprise à l'aide des références aux dessins sur lesquels :
- la figure 1 est une représentation schématique en coupe médiane et longitudinale d'un exemple de réacteur conforme à la présente invention ;
- la figure 2 est une représentation en perspective éclatée de l'agencement des premiers moyens de chauffage et du conduit, entrant dans la composition du réacteur représenté sur la figure 1 ;
- la figure 3 est une vue en élévation de dessus d'une pièce permettant de maintenir le conduit à l'intérieur de l'enceinte du réacteur représenté à la figure 1 ; et
- la figure 4 est une représentation schématique en coupe médiane longitudinale d'un autre exemple de réacteur conforme à la présente invention, et
- la figure 5 est une représentation schématique en coupe médiane longitudinale d'encore un autre exemple de réacteur conforme à la présente invention.

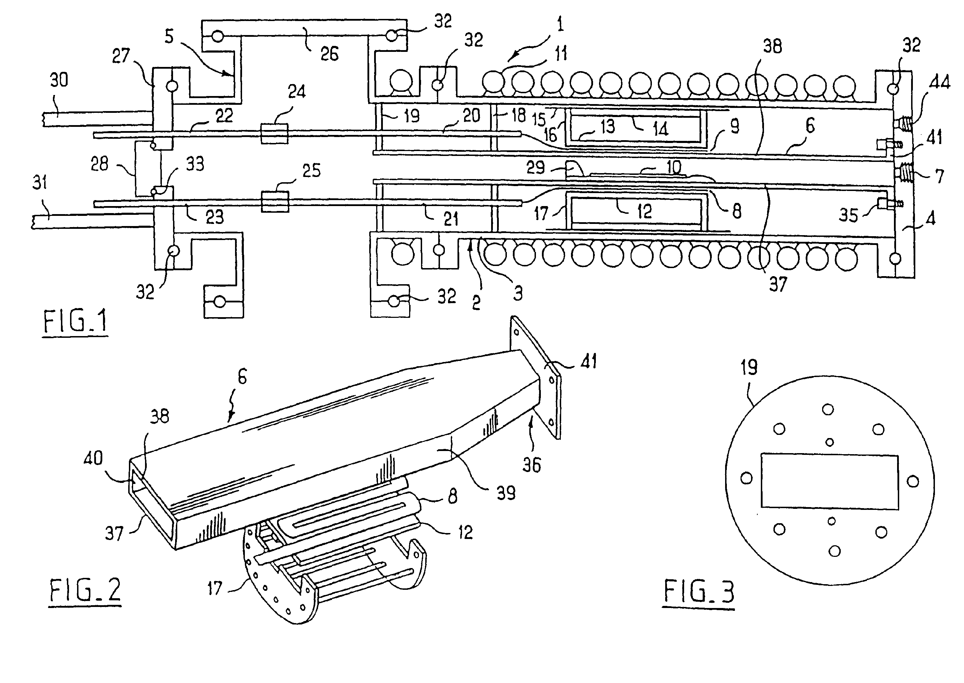

Un exemple non limitatif de réacteur selon l'invention est représenté à la figure 1. Ce réacteur 1 comprend une enceinte 2 constituée d'un tube 3, d'un premier obturateur 4 situé à l'une des extrémités de ce tube 3, et d'une croix de sortie 5 située à l'extrémité opposée du tube 3, par rapport au premier obturateur 4. L'ensemble du réacteur 1 est étanche et peut éventuellement résister à une pression de quelques MPa. L'étanchéité du réacteur 1 est assurée par des joints 32, 33.

La croix de sortie 5 peut être remplacée par un élément en forme de « T ».

L'axe du tube 3 est à l'horizontal. A l'intérieur du tube 3 est disposé un conduit 6 coaxial à celui-ci. A l'extérieur du tube 3 sont disposés des moyens de refroidissement 11 aptes à refroidir le tube 3. Le tube 3 est avantageusement un cylindre en acier inoxydable.

La croix 5 est de préférence fixe car l'une de ses sorties est reliée au système de pompage.

La croix de sortie 5 comporte un orifice inférieur et un orifice supérieur, radialement opposés dans la direction verticale. L'orifice inférieur de cette croix de sortie 5 débouche soit sur une pompe et un régulateur de pression pour les basses pressions, soit sur un détendeur pour une pression supérieure à la pression atmosphérique, ceci afin d'évacuer les gaz à pression constante. Ces appareils ne sont pas représentés sur la figure 1. L'orifice supérieur de la croix de sortie 5 est obturé hermétiquement par un deuxième obturateur 26. La croix de sortie 5 possède en outre un orifice longitudinalement opposé au tube 3. Cet orifice peut être éventuellement muni d'un passage tournant. Dans le mode de réalisation ici présenté, cet orifice est obturé par un troisième obturateur 27 perpendiculaire à l'axe du tube 3. Le troisième obturateur 27 peut éventuellement être équipé d'une fenêtre ou d'un miroir mobile pour des mesures optiques à l'intérieur du conduit 6. Ce troisième obturateur 27 comporte une porte hermétique 28 permettant d'introduire ou d'extraire des substrats 10 du réacteur 1. Le troisième obturateur 27 comporte aussi des guides 30, 31. Ces guides 30, 31 sont perpendiculaires au plan de l'obturateur 27 et sont fixés solidairement à celui-ci. Ces guides 30, 31 servent à guider horizontalement un manipulateur non représenté sur les figures. Le troisième obturateur 27 comporte aussi des passages pour des premières amenées de courant 22, 23. Les parties des premières amenées de courant 22, 23, situées vers l'intérieur de l'enceinte 2, sont munies de connecteurs 24, 25.

Le conduit 6 est positionné et maintenu dans le tube 3 grâce à des moyens de fixation 35 du conduit 6 sur le premier obturateur 4. Ainsi, le conduit 6 est maintenu de manière à être libre de tout contact avec le tube 3. Ce qui permet de limiter les pertes par conduction thermique et d'éviter les contraintes thermiques.

Comme représenté sur la figure 2, le conduit 6 a une forme de tube à section transversale rectangulaire, présentant un rétrécissement 36 à une extrémité de celui-ci. Ce conduit 6 comporte deux plaques pour former des parois inférieure 37 et supérieure 38. Les parois inférieure 37 et supérieure 38 du conduit 6 sont horizontales et parallèles au plan du substrat 10 dans la position qu'il occupe pendant le dépôt. Des parois latérales 39, 40 joignent les bords longitudinaux des parois inférieure 37 et supérieure 38, pour fermer le conduit 6 longitudinalement. L'extrémité du conduit 6 située du côté du rétrécissement 36 a une section transverse carrée. Elle est munie d'une plaque support 41 perpendiculaire à l'axe longitudinal du conduit 6. Cette plaque support 41 présente une ouverture en vis-à-vis de l'embouchure du conduit 6 située du côté du rétrécissement 36. La plaque support 41 présente aussi des trous pour permettre la fixation du conduit 6 sur le premier obturateur 4, grâce aux moyens de fixation 35. Lorsque le conduit 6 est fixé sur le premier obturateur 4, l'embouchure du conduit 6 située du côté du rétrécissement 36 et l'ouverture dans la plaque support 41 se trouvent en vis-à-vis d'une entrée de gaz 7. Le conduit 6 est raccordé de manière étanche au premier obturateur 4, au niveau de l'entrée de gaz 7. La jonction étanche du conduit 6 sur le premier obturateur 4 est assurée par serrage d'un joint de graphite par exemple, grâce aux moyens de fixation 35.

L'entrée de gaz 7 sert à l'alimentation du réacteur 1 en gaz porteurs et précurseurs. Le premier obturateur 4 est aussi muni d'un passage de gaz 44, désaxé par rapport à l'axe de symétrie perpendiculaire au plan du disque que constitue le premier obturateur 4, et débouchant entre le conduit 6 et la paroi du tube 3. Le passage de gaz 44 permet aussi l'introduction de gaz dans le réacteur 1. Le passage de gaz 44 permet de faire circuler un gaz neutre vis-à-vis de l'ensemble des matériaux compris dans le réacteur 1 et vis-à-vis du matériau à déposer et des gaz circulant dans le conduit 6, ce gaz neutre empêchant le retour éventuel des gaz issus du procédé vers les parties chauffantes extérieures au conduit 6.

Préférentiellement, le conduit 6 est dans un matériau qui est à la fois bon conducteur thermique, bon isolant électrique, très réfractaire, très stable chimiquement et a une faible tension de vapeur aux températures d'utilisation, bien qu'éventuellement, un dépôt préalable du matériau destiné à être déposé sur un substrat 10 dans ce réacteur 1, puisse être réalisé sur la face interne des parois 37, 38, 39, 40 du conduit 6, afin de minimiser la diffusion d'éventuels produits de dégazage pendant le fonctionnement normal du réacteur 1.

Avantageusement encore, ce matériau a une bonne tenue mécanique pour tolérer une faible épaisseur des parois 37, 38, 39, 40 du conduit 6. La faible épaisseur de ces parois 37, 38, 39, 40 permet de minimiser les pertes par conduction thermique.

La tenue mécanique du matériau du conduit est aussi importante pour pouvoir supporter ce conduit 6 uniquement par son extrémité située du côté du rétrécissement 36 et la plaque support 41.

Le matériau constitutif du conduit 6 est avantageusement du nitrure de bore pour une utilisation à des températures inférieures à 1200° C ou à plus hautes températures, si la présence d'une concentration élevée d'azote ne nuit pas à la qualité attendue du matériau élaboré.

Pour des températures plus élevées , le conduit 6 peut être réalisé en graphite. Dans un cas, comme dans l'autre, le conduit 6 peut être doublé intérieurement dans les parties les plus chaudes par un conduit secondaire en un matériau réfractaire, par exemple en métal réfractaire, inerte vis-à-vis des gaz circulant dans le conduit 6 et non polluant vis-à-vis du matériau déposé. Le conduit 6, qu'il soit en graphite ou en nitrure de bore, peut être réalisé soit par dépôt pyrolitique, soit par assemblage et/ou collage des différentes plaques constitutives des parois 37, 38, 39, 40 et de la plaque de support 41. Le conduit secondaire, quand il existe, double avantageusement intérieurement le conduit 6 de manière continue, c'est à dire que s'il est constitué de plaques, celles-ci sont jointives et qu'il n'y a pas de trous dans ces plaques. Le conduit secondaire est, par exemple, en tungstène, en tantale, en molybdène, en graphite ou en nitrure de bore.

A titre d'exemple, l'épaisseur des parois du conduit 6 est inférieure ou égale à environ 1 mm ; la hauteur interne du conduit 6 est préférentiellement inférieure à 30 mm ; la largeur du conduit 6 est égale à la largeur d'un substrat 10 ou à la somme des largeurs des substrats 10 traités au cours d'un même dépôt, plus environ 1 cm entre le ou les substrats 10 et les parois 39 et 40.

La partie du conduit 6 correspondant au rétrécissement 36, correspond à environ 1/5 de la longueur totale du conduit 6. La longueur de la partie à section constante du conduit 6 est égale à environ cinq fois le diamètre ou la longueur du plus grand substrat 10 que l'on veut utiliser ou cinq fois la somme des diamètres ou longueurs des substrats 10 sur lesquels un dépôt peut être effectué au cours de la même opération. Cette partie du conduit 6 s'étendant sur une longueur correspondant au diamètre ou à la longueur d'un substrat ou à la somme des longueurs ou des diamètres des substrats, est appelée ci-dessous zone de dépôt.

Avantageusement, le réacteur 1 est muni de premiers 8 et deuxièmes 9 moyens de chauffage, disposés au niveau de la zone de dépôt et situés de part et d'autre du plan du substrat 10.

Avantageusement, ces premiers 8 et deuxièmes 9 moyens de chauffage sont constitués d'éléments résistifs nus, c'est-à-dire que le matériau constitutif des premiers 8 et deuxièmes 9 moyens de chauffage est en contact direct avec le gaz circulant entre le conduit 6 et le tube 3.

Chaque élément résistif correspondant respectivement aux premiers 8 ou aux deuxièmes 9 moyens de chauffage est constitué d'une bande, c'est-à-dire un élément de plaque rigide, ou d'un ruban disposé(e) à plat, parallèlement aux parois inférieure 37 et supérieure 38 du conduit 6 (fig. 2). Ce ruban ou cette bande a une géométrie adaptée pour que, dans la zone de dépôt, les écarts à la température moyenne, sur la surface du substrat 10 destinée au dépôt, soient minimisés. Préférentiellement encore, ces écarts sont inférieurs à 3°C. Préférentiellement, chaque élément résistif a une dimension dans la direction parallèle à la largeur du conduit 6 qui est approximativement égale à cette dernière. La dimension de chaque élément résistif dans la direction parallèle à la longueur du conduit 6 est environ égale à deux fois la longueur de la zone de dépôt. Ceci pour optimiser l'uniformité du champ de température dans la zone de dépôt. Préférentiellement, chaque bande ou ruban d'un élément résistif est constitué(e) de bandes parallèles les unes aux autres, dans la direction longitudinale du tube 3, jointes deux à deux alternativement à l'une ou l'autre de leurs extrémités, de manière à former une géométrie en zigzag. D'autres géométries sont envisageables, telles des géométries en spirale.

Chaque élément résistif peut avoir un profil longitudinal de résistance par exemple obtenu en jouant sur son épaisseur, adapté pour favoriser la formation d'un profil de température contrôlé dans la zone de dépôt.

Chaque élément résistif a un grand coefficient de remplissage dans la zone de dépôt afin que leur température reste aussi peu que possible supérieure à la température locale souhaitée.

L'espace entre les bandes des éléments résistifs est suffisant pour éviter un arc ou un court circuit mais est suffisamment faible aussi pour conserver une homogénéité du champ de température acceptable et pour qu'il ne soit pas nécessaire que sa température soit beaucoup plus élevée que celle du conduit qui est elle-même celle à laquelle se fait le dépôt. Préférentiellement, les premiers 8 et deuxièmes 9 moyens de chauffage sont alimentés sous une tension inférieure ou égale à 240 volts et plus préférentiellement encore inférieure ou égale à 100 ou 110 volts.

Eventuellement, les moyens premiers 8 et deuxièmes 9 moyens de chauffage sont chacun constitues de plusieurs éléments résistifs du type de ceux décrits ci-dessus.

Avantageusement, les éléments résistifs sont réalisés dans un matériau conducteur électrique et réfractaire à très faible tension de vapeur aux températures d'utilisation. Ce matériau peut être par exemple du graphite, un métal tel que le tantale ou le tungstène, ou encore un alliage réfractaire, etc. Préférentiellement, il s'agit de graphite de haute pureté.

Les premiers 8 et deuxièmes 9 moyens de chauffage sont alimentés en courant indépendamment l'un de l'autre, de manière à pouvoir être portés à des températures différentes. On peut aussi générer un gradient de température perpendiculairement au plan du substrat 10. Ce gradient peut être de valeur positive, négative ou nulle par un contrôle indépendant de la puissance électrique appliquée à un des premiers 8 ou deuxièmes 9 moyens de chauffage.

Les premiers 8 ou les deuxièmes 9 moyens de chauffage peuvent être respectivement appliqués au contact des parois inférieure 37 et supérieure 38, à l'extérieur du conduit 6, au niveau de la zone de dépôt. Mais selon une variante ceux-ci sont positionnés chacun respectivement à une distance de 1 à 3 mm d'une des parois inférieure 37 ou supérieure 38, à l'extérieur du conduit 6. Les premiers 8 et les deuxièmes 9 moyens de chauffage sont maintenus plaqués contre les parois inférieure 37 et supérieure 38 par des plaques de maintien 12, 13 électriquement isolantes et thermiquement conductrices. Dans le cas où le conduit 6 n'est pas un matériau électriquement isolant, il faut mettre entre le conduit 6 et les premiers 8 et deuxièmes 9 moyens de chauffage, un matériau intermédiaire, électriquement isolant, pour éviter tout contact électrique, surtout dans la zone chaude, si de très hautes températures doivent être atteintes.

Ces plaques de maintien 12, 13 peuvent être en nitrure de bore et faire 1 mm d'épaisseur environ ou moins encore. Il est aussi particulièrement intéressant de confiner les plaques de maintien 12, 13 aux extrémités les plus froides des éléments du conduit 6, afin d'éviter la décomposition du nitrure de bore et la formation d'azote. Des fourreaux en nitrure de bore destinés à recevoir des thermocouples 51 peuvent être collés sur les plaques de maintien 12, 13, mais ils peuvent aussi être libres au dessus des premiers 8 et deuxièmes 9 moyens de chauffage.

Ces thermocouples 51 (non représentés sur les figures 1 à 3) servent à mesurer la température du conduit 6, à la réguler et à en contrôler l'homogénéité dans la zone de dépôt. Ils sont utilisables pour des températures inférieures à 1700°C (pour des températures supérieures à 1700°C, la température devra être mesurée par pyrométrie optique ou par des thermocouples sans contacts). La soudure chaude de ces thermocouples 51 est située à l'extérieur du conduit 6 au plus près des premiers 8 et deuxièmes 9 moyens de chauffage.

Comme on l'a représenté à la figure 2, les premiers 8 et deuxièmes 9 moyens de chauffage, ainsi que les plaques de maintien 12, 13 sont maintenus ensemble et contre le conduit 6 grâce à des berceaux 16, 17. Chaque berceau 16, 17 est constitué de deux demi-disques parallèles l'un à l'autre et reliés entre eux par des tiges qui leur sont perpendiculaires. Le diamètre des disques, constitués de deux demi-disques, est légèrement inférieur au diamètre interne du tube 3. Le bord rectiligne des deux demi-disques est dans un plan horizontal. Chaque bord rectiligne de chaque demi-disque comprend des encoches aptes à accueillir une plaque de maintien 12 ou 13, les premiers 8 ou les deuxièmes 9 moyens de chauffage, ainsi qu'une moitié de la hauteur du conduit 6. Les éléments résistifs des premiers 8 et deuxièmes 9 moyens de chauffage sont tenus isolés du conduit 6 par les berceaux 16, 17.

Lorsque le conduit 6 est en graphite, c'est à dire lorsqu'il est conducteur, les premiers 8 et deuxièmes 9 moyens de chauffage peuvent être en graphite rigide. Ils sont alors isolés électriquement du conduit 6 par des cales, par exemple en nitrure de bore, qui les écartent du conduit 6 de quelques millimètres. Ces cales peuvent être fixées aux extrémités des premiers 8 et deuxièmes 9 moyens de chauffage et donc ne pas être trop chauffées. Une ou plusieurs gaines en graphite ou en nitrure de bore peuvent être fixées sur les faces du conduit 6 pour recevoir des thermocouples eux-mêmes isolés dans des gaines réfractaires et isolantes électriquement.

L'encombrement de ces berceaux 16, 17 dans la direction parallèle à l'axe longitudinal du conduit 6 correspond approximativement à la longueur des premiers 8 ou deuxièmes 9 moyens de chauffage, dans cette direction.

Ces berceaux 16, 17 sont placés approximativement au milieu du conduit 6, considéré dans sa direction longitudinale.

Avantageusement, les demi disques des berceaux 16, 17 sont au contact du conduit 6 dans les parties froides de celui-ci.

Des écrans thermiques 14, 15 sont placés de part et d'autre des premiers 8 et deuxièmes 9 moyens de chauffage, à l'extérieur de ces derniers. Plus précisément, des écrans thermiques 15 sont situés entre la paroi interne du tube 3 et la partie curviligne des demi-disques constitutifs des berceaux 16, 17. Ils s'étendent sous la face interne du tube 3, mais sans contact avec celui-ci de manière concentrique, autour de la zone de chauffage. D'autres écrans thermiques 14 sont placés entre les plaques de maintien 12, 13 et les précédents 15. Ces écrans thermiques 14, 15 sont composés de deux ou trois feuilles fines en métal poli, réfléchissant et réfractaire tel que le tantale, le molybdène, etc. L'écran thermique 14 ou 15 le plus externe est au plus près à quelques millimètres de la paroi interne du tube 3. Cette configuration longitudinale, avec les premiers 8 et deuxièmes 19 moyens de chauffage à l'intérieur du tube 3, au contact du conduit 6, et deux ou trois écrans thermiques 14, 15 limite beaucoup les pertes par rayonnement qui seraient autrement très importantes aux hautes températures, telles que celles exigées pour le dépôt de carbure de silicium.

Les demi-disques des berceaux 16, 17 sont constitués dans un matériau isolant électriquement et thermiquement. Ainsi les écrans thermiques 14, 15 sont isolés électriquement et thermiquement entre eux et des moyens de chauffage 8, 9.

L'ensemble constitué par le conduit 6, les premiers 8 et deuxièmes 9 moyens de chauffage, les plaques de maintien 12, 13, les berceaux 16, 17 qui maintiennent ensemble tous ces éléments, ainsi que les écrans thermiques 14, 15, est placé dans le tube 3. Cet ensemble limite la circulation de gaz à l'extérieur de la partie chaude du conduit et participe ainsi à limiter les pertes thermiques.

Avantageusement, deux disques 18, 19 sont placés entre les berceaux 16, 17 et la croix de sortie 5, perpendiculairement à l'axe du tube 3.

Comme représenté à la figure 3, ces disques 18, 19 sont munis d'une ouverture centrale rectangulaire dont la superficie correspond approximativement à la section transversale le conduit 6, de manière à pouvoir enfiler ces disques 18, 19 sur le conduit 6. Ces disques 18, 19 comportent aussi des trous périphériques à l'ouverture centrale, destinés au passage de deuxièmes amenées de courant 20, 21, et de fils des thermocouples 51. L'un 19 de ces disques 18, 19 est placé dans la croix de sortie 5. L'autre 18 de ces disques 18, 19 est placé entre le disque 19 et les berceaux 16, 17. Ces disques 18, 19 ont pour rôle de maintenir ensemble le conduit 6, des deuxièmes amenées de courant 20, 21 et les fils des thermocouples 51, ainsi que celui de limiter les échanges gazeux entre l'intérieur du conduit 6 et l'espace situé entre le conduit 6 et le tube 3. Toutefois, les disques 18, 19 doivent permettre un passage des gaz, en provenance de la sortie du conduit 6, entre l'espace intérieur du conduit 6 et l'espace situé entre le conduit 6 et le tube 3, de manière à ce que la pression soit équilibrée de part et d'autre des parois 37, 38, 39, 40. En équilibrant ainsi la pression de part et d'autre des parois 37, 38, 39, 40, il est permis de réaliser ces dernières avec une faible épaisseur.

Les paires des deuxièmes amenées de courant 20, 21 sont connectées aux premières amenées de courant 22, 23 grâce aux connecteurs 24, 25. Les thermocouples 51 sont aussi connectés à l'extérieur de l'enceinte 2 par l'intermédiaire de connecteurs situés dans l'enceinte 2.

Les disques 18, 19 peuvent être constitués d'un matériau isolant électriquement et thermiquement mais pas nécessairement très réfractaire.

La porte hermétique 28 couvre une ouverture dont la largeur est approximativement égale à celle du conduit. Cette ouverture est située dans l'axe du conduit 6. Elle permet l'introduction et l'extraction des substrats 10. Un sas d'entrée est éventuellement connecté au troisième obturateur 27 pour éviter la remise à l'air du réacteur 1 pendant les opérations d'introduction et extraction des substrats 10.

Les substrats 10 sont avantageusement introduits dans le réacteur 1 grâce à un porte-substrat 29. Le porte-substrat 29 est avantageusement constitué d'un matériau bon conducteur thermique de manière à ce qu'il ait peu d'inertie thermique. Préférentiellement, ce porte-substrat 29 est réalisé en nitrure de bore, mais il peut aussi être en graphite par exemple. Le porte-substrat 29 est introduit dans le réacteur 1 par un manipulateur à pinces qui coulisse sur les guides 30, 31. Ce manipulateur est constitué d'un tube fin et rigide coaxial à l'axe du conduit 6, d'une longue tige filetée à l'intérieur de ce tube, solidaire du côté du réacteur 1, de deux éléments de pinces symétriques et articulés autour d'une charnière verticale, l'extrémité extérieure de la tige filetée étant vissée dans un écrou prisonnier tournant librement. En vissant l'écrou, la tige filetée recule et la pince se resserre fermement sur une partie verticale du porte-substrat 29. Le manipulateur peut alors être mu le long des guides 30, 31 pour introduire ou extraire le porte-substrat 29. Une came sur le manipulateur peut être prévue pour permettre de surélever la pince quand celle-ci vient de saisir le porte-substrat 29, dans sa position à l'intérieur du conduit 6, de manière à ce que celui-ci ne frotte pas la face interne de la paroi 37.

Avant la mise en service du réacteur 1, un dépôt du produit majoritaire auquel est dédié le réacteur 1 est déposé dans le conduit 6 sans substrat 10, ni porte-substrat 29 après un dégazage poussé, à une température supérieure à la temperature habituelle de dépôt et un bon balayage par le gaz vecteur Cette etape peut être suivie par un dépôt analogue sur le porte-substrat 29 sans substrat 10. Le réacteur est alors prêt à l'emploi.

Le procédé et le réacteur selon l'invention peuvent faire l'objet de nombreuses variantes.

On a décrit ci-dessus des premiers 8 et deuxièmes 9 moyens de chauffage résistifs. Ce type de moyens de chauffage permet de monter à des températures supérieures à 1750°C, avec un faible investissement en matériaux et une consommation d'énergie plus faible qu'avec les procédés et les réacteurs de l'art antérieur. Cependant, il peut être envisagé d'autres types de moyens de chauffage 8, 9 même si ceux-ci apparaissent moins avantageux, tels des moyens de chauffage par induction, des moyens de chauffage dans lesquels les premiers 8 et deuxièmes 9 moyens de chauffage ne forment qu'un dispositif unique disposé tout autour du conduit 6, etc.

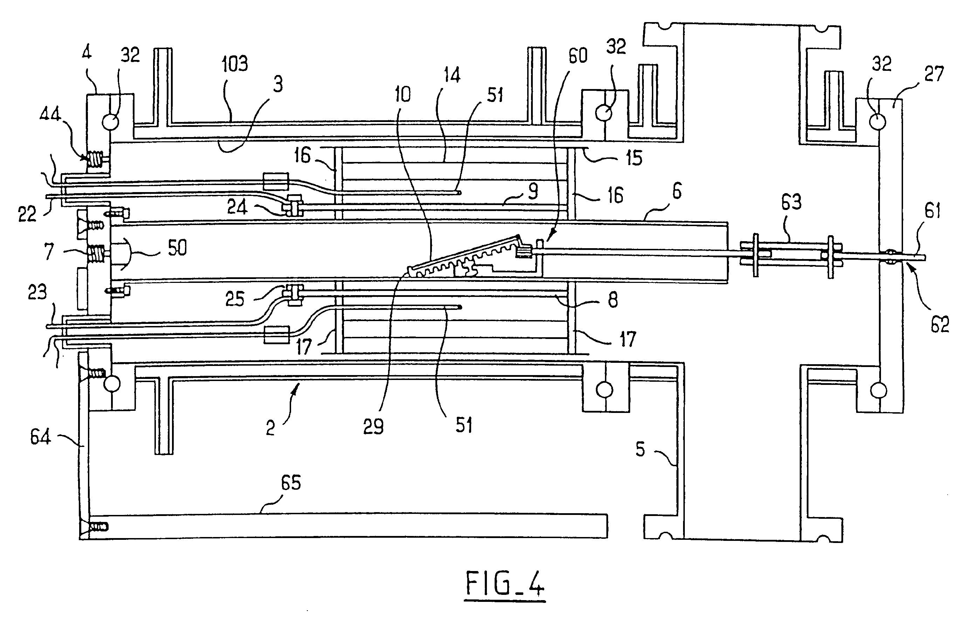

Sur la figure 4 est représenté un autre mode de réalisation du réacteur 1 selon l'invention. Selon ce mode de réalisation, le réacteur 1 comprend une enceinte 2 constituée de deux tubes 3, 103 en acier inoxydable, concentriques, dont l'axe de révolution commun est horizontal. Dans l'espace entre les deux parois de ces tubes 3, 103 circule un fluide de refroidissement.

Un brise jet 50 est monté dans l'axe de l'entrée de gaz 7 de manière à favoriser l'obtention d'une bonne uniformité de la vitesse des gaz. Le passage de gaz 44 peut aussi éventuellement être muni d'un brise jet.

Un mécanisme 60 entraîné par un arbre 61, passant par une traversée étanche 62, et un accouplement coulissant 63, permet la rotation du substrat 10 afin d'assurer une plus grande uniformité du dépôt.

Toutes les connexions électriques et fluides sur le troisième obturateur 27 et le premier obturateur 4 sont suffisamment longues et souples pour pouvoir déplacer celles-ci d'environ deux fois la longueur du conduit 6. Avantageusement, les connexions peuvent aussi être faites uniquement sur le premier obturateur 4.

Le premier obturateur 4 est solidaire d'un chariot comprenant un support vertical 64 et un support horizontal 65.

Le support horizontal 65 peut être déplacé parallèlement à l'axe du tube 3, sur un chemin de roulement non représenté. Pour monter l'ensemble du conduit 6 et ses équipements, le premier obturateur 4 est ouvert, le tube 3 restant solidaire de la croix 5.

Pour charger ou décharger un substrat 10 on a le choix entre ouvrir le troisième obturateur 27 ou séparer le tube 3 de la croix 5.

Les substrats 10 sont introduits et maintenus dans la zone de dépôt par un porte-substrat 29 en graphite qui peut être relevé de quelques degrés, du côté aval par rapport à l'écoulement des gaz, de manière à offrir une plus grande surface de projection sur un plan vertical, dans le conduit 6. Le porte substrat est par exemple constitué d'un disque avec un rebord. Le rebord est avantageusement d'une hauteur supérieure à la hauteur du substrat 10. Le porte-substrat 29 peut entraîner en rotation le substrat 10 qu'il supporte, de manière à assurer une meilleure uniformité du dépôt. Ceci s'effectue avantageusement, grâce à une transmission mécanique, constituée d'un pignon conique d'axe horizontal et solidaire de l'arbre 61, lui même en rotation grâce à un moteur extérieur au réacteur 1, à vitesse variable assurant une vitesse de rotation du substrat pouvant aller jusqu'à 10 tours par seconde.

Selon une variante avantageuse, non représentée, du réacteur conforme à la présente invention, celui-ci comporte des premiers 8 et deuxièmes moyens de chauffage, décalés l'un par rapport à l'autre dans le sens longitudinal du conduit 6. Ceci permet également d'homogénéiser la distribution de la température sur toute la surface du substrat en favorisant la formation d'un plateau dans le profil longitudinal de température.

Selon une autre variante avantageuse, le centre du substrat 10 sur le porte substrat 29 est décalé vers l'aval du flux gazeux, dans la zone des premiers 8 et deuxièmes 9 moyens de chauffage, sans néanmoins que le substrat 10 ne sorte de cette zone.

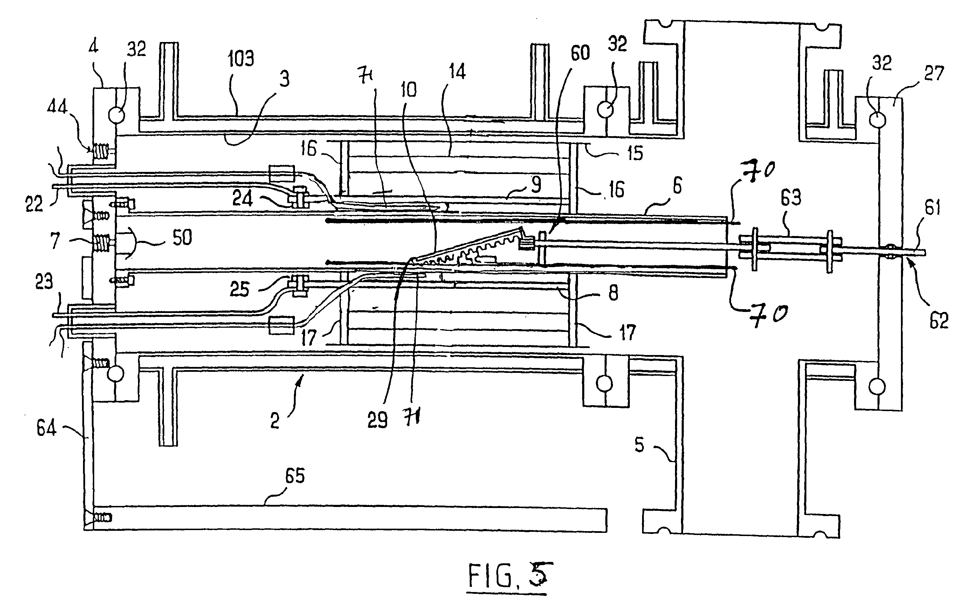

Selon encore une autre variante, illustrée par la figure 5, le conduit secondaire est constitué de plaques 70 amovibles, pouvant être introduites et retirées facilement par glissement dans des rainures non représentées du conduit 6. Ces plaques 70 sont utiles pour protéger le conduit 6 des dépôts hors du (des) substrats(s) 10. Elles sont d'un entretien aisé et sont avantageusement en graphite en nitrure de bore ou en un autre matériau réfractaire compatible avec la température du procédé et le milieu ambiant.

Selon une autre variante avantageuse aussi représentée sur la figure 5, la température peut être mesurée par des fibres 71 de pyromètres optiques situées dans des gaines solidaires du conduit 6 et entre le conduit 6 et les premiers 8 et deuxièmes 9 moyens de chauffage, plutôt que par des thermocouples 51, ceci afin d'augmenter la durée de vie des moyens de mesure de la température.

Le procédé selon l'invention permet d'obtenir les avantages précités tout en conservant un taux d'impuretés dans les couches obtenues équivalent à ceux des couches obtenues grâce aux procédés et aux réacteurs de l'art antérieur.

Un procédé et un réacteur selon l'invention sont particulièrement bien adaptés à la croissance de couches de carbure de silicium ou de nitrure d'aluminium sur des substrats 10.

## Revendications

1. Procédé de dépôt en phase vapeur de couches d'un matériau sur un substrat (10) s'étendant globalement dans un plan, comprenant
- une étape consistant à disposer le substrat (10) dans un conduit (6) constitué d'un matériau réfractaire et balayé par les composés gazeux nécessaires au dépôt ;
- une étape consistant à chauffer le substrat (10) pour générer un gradient de température, perpendiculairement au plan du substrat (10) et orienté dans un premier sens :
**caractérisé par le fait que** l'étape de génération du gradient s'effectue grâce au chauffage du substrat par le rayonnement de la chaleur du conduit (6), le conduit étant très stable chimiquement vis à vis des composés gazeux et bon conducteur thermique, et absorbant le rayonnement émis par des premiers et deuxièmes moyens de chauffage situés à l'extérieur du conduit (6) et constitués d'éléments résistifs nus, le chauffage du conduit par les premiers et deuxièmes moyens de chauffage pour la génération du gradient s'effectuant en alimentant en courant les premiers (8) et deuxièmes (9) moyens de chauffage indépendamment les uns des autres.

2. Procédé selon la revendication 1. **caractérisé par le fait qu'**il comprend une étape consistant à inverser le sens du gradient de température par rapport au premier sens.

3. Procédé selon la revendication 1, **caractérisé en ce qu'**il comprend une étape consistant à disposer au moins un écran thermique (14,15) autour des premiers (8) et deuxièmes (9) moyens de chauffage.

4. Procédé selon l'une des revendications précédentes, **caractérisé par le fait qu'**il comprend une étape consistant à faire circuler un gaz neutre vis-à-vis de l'ensemble des matériaux compris dans le réacteur et vis-à-vis du matériau à déposer et des gaz circulant dans le conduit (6).

5. Réacteur de dépôt en phase vapeur de couches d'un matériau sur un substrat (10) s'étendant principalement dans un plan, comprenant :
- un conduit (6) constitué d'un matériau réfractaire,
- des premiers (8) et deuxièmes (9) moyens de chauffage et situés de part et d'autre du plan du substrat (10) à l'extérieur du conduit (6), et
- des moyens (7) pour introduire dans le conduit (6) les composés gazeux nécessaires au dépôt,
**caractérisé par le fait que**
- les premiers et deuxièmes moyens de chauffage sont constitués d'éléments résistifs nus et sont aptes à être alimentés en courant indépendamment les uns des autres pour chauffer une paroi supérieure et/ou inférieure du conduit (6),
- et **par le fait que** le conduit est très stable chimiquement vis à vis des composés gazeux et est bon conducteur thermique, et absorbe le rayonnement émis par les premiers et deuxièmes moyens de chauffage, le substrat étant apte à être chauffé par le rayonnement de la chaleur du conduit.

6. Réacteur selon la revendication 5, **caractérisé par le fait que** le conduit (6) a une section rectangulaire, et comprend deux plaques formant parois inférieure (37) et supérieure (38) horizontales et parallèles au plan du substrat (10) dans la position qu'il occupe pendant le dépôt.

7. Réacteur selon l'une des revendications 5 à 6. **caractérisé par le fait qu'**il comprend au moins un écran thermique (14,15) autour des premiers (8) et deuxièmes (9) moyens de chauffage.

8. Réacteur selon la revendication 7, **caractérisé par le fait que** l'ensemble constitué par le conduit (6), les premiers (8) et deuxièmes (9) moyens de chauffage et chaque écran thermique (14,15), est placé dans un tube (3).

9. Réacteur selon la revendication 8, **caractérisé par le fait que** le conduit (6) est maintenu dans le tube (3), de manière à être libre de tout contact avec le tube (3).

10. Réacteur selon l'une des revendications 8 et 9, **caractérisé par le fait qu'**un passage de gaz peut s'effectuer par la sortie du conduit (6) entre l'espace intérieur du conduit (6) et l'espace situé entre le conduit (6) et le tube (3), de manière à équilibrer la pression sur les parois (37. 38, 39, 40) du conduit (6).

11. Réacteur selon la revendication 10, **caractérisé par le fait que** les parois (37, 38. 39, 40) du conduit (6) ont une épaisseur inférieure ou égale à un millimètre.

12. Réacteur selon l'une des revendications 6 à 11, **caractérisé par le fait que** les premiers (8) et deuxièmes (9) moyens de chauffage sont constitués d'un ruban ou d'une bande de graphite disposé(e) à plat, parallèlement aux parois inférieure (37) et supérieure (38) du conduit (6), selon une géométrie adaptée pour que, dans la zone de dépôt, les écarts à la température moyenne, sur la surface du substrat (10) destinée au dépôt, soient inférieurs à 3°C.

13. Réacteur selon l'une des revendications 6 à 12, **caractérisé par le fait que** les premiers (8) et deuxièmes (9) moyens de chauffage sont positionnés chacun respectivement à une distance de 1 à 3mm d'une des parois inférieure (37) ou supérieure (38) à l'extérieur du conduit (6).

14. Réacteur selon l'une des revendications 5 à 13, **caractérisé par le fait que** les premiers (8) et deuxièmes (9) moyens de chauffage peuvent être portés à des températures différentes.

15. Réacteur selon l'une des revendications 5 à 14, **caractérisé par le fait que** les premiers (8) et deuxièmes (9) moyens ne forment qu'un dispositif de chauffage unique disposé tout autour du conduit.

16. Réacteur selon l'une des revendications 5 et 15, **caractérisé par le fait que** les premiers (8) et deuxièmes (9) moyens de chauffage sont disposés au niveau de la zone dépôt.

17. Réacteur selon l'une des revendications 8 à 16, **caractérisé par le fait que** les moyens de chauffages (8.9) sont alimentés sous une tension inférieure ou égale à 240 volts.

18. Réacteur selon l'une des revendications 5 à 17, **caractérisé par le fait que** le conduit (6) est doublé intérieurement dans les parties les plus chaudes, de manière continue par un conduit secondaire en matériau réfractaire bon conducteur thermique et très stable chimiquement vis à vis des composés gazeux.

19. Réacteur selon l'une des revendications 5 à 18, **caractérisé par le fait que** les premiers (8) et deuxièmes (9) moyens de chauffage sont décalés l'un par rapport à l'autre dans le sens longitudinale du conduit (6).

## Claims

1. Process for the vapour deposition of layers of a material on a substrate (10) which extends generally in a plane, comprising:
- a step consisting in placing the substrate (10) in a duct (6) made of a refractory material and swept by the gaseous compounds necessary for the deposition;
- a step consisting in heating the substrate (10) so as to generate a temperature gradient perpendicular to the plane of the substrate (10) and oriented in a first direction;
**characterized in that** the step of generating the gradient is carried out by heating the substrate by the radiation from the heat of the duct (6), the duct being chemically very stable in relation to the gaseous compounds and a good thermal conductor, and absorbing the radiation emitted by first and second heating means situated outside the duct (6) and consisting of bare resistive elements, the heating of the duct by the first and second heating means for the generation of the gradient being carried out by supplying current to the first (8) and second (9) heating means independently of one another.

2. Process according to Claim 1, **characterized in that** it comprises a step consisting in reversing the direction of the temperature gradient with respect to the first direction.

3. Process according to Claim 1, **characterized in that** it comprises a step consisting in placing at least one heat shield (14, 15) around the first (8) and second (9) heating means.

4. Process according to one of the preceding claims, **characterized in that** it comprises a step consisting in creating a flow of a gas which is inert with respect to ail of the materials included in the reactor and with respect to the material to be deposited and to the gases flowing in the duct (6).

5. Reactor for the vapour deposition of layers of a material on a substrate (10) which extends mainly in a plane, comprising:
- a duct (6) made of a refractory material,
- first (8) and second (9) heating means situated on either side of the plane of the substrate (10) outside the duct (6), and
- means (7) for introducing into the duct (6) the gaseous compounds necessary for the deposition,
**characterized in that**
- the first and second heating means consist of bare resistive elements and are able to be supplied with current independently of one another in order to heat an upper and/or lower wall of the duct (6),
- and **in that** the duct is chemically very stable in relation to the gaseous compounds and is a good thermal conductor, and absorbs the radiation emitted by the first and second heating means, the substrate being able to be heated by the radiation from the heat of the duct.

6. Reactor according to Claim 5, **characterized in that** the duct (6) has a rectangular cross section and comprises two plates forming lower (37) and upper (38) walls which are horizontal and parallel to the plane of the substrate (10) in the position that it occupies during the deposition.

7. Reactor according to either of Claims 5 and 6, **characterized in that** it comprises at least one heat shield (14, 15) around the first (8) and second (9) heating means.

8. Reactor according to Claim 7, **characterized in that** the assembly consisting of the duct (6), the first (8) and second (9) heating means and each heat shield (14, 15) is placed in a tube (3).

9. Reactor according to Claim 8, **characterized in that** the duct (6) is held in place in the tube (3) so as to be free of any contact with the tube (3).

10. Reactor according to either of Claims 8 and 9, **characterized in that** gas may be made to pass via the outlet of the duct (6) between the internal space of the duct (6) and the space lying between the duct (6) and the tube (3), so as to balance the pressure on the walls (37, 38, 39, 40) of the duct (6).

11. Reactor according to Claim 10, **characterized in that** the walls (37, 38, 39, 40) of the duct (6) have a thickness of less than or equal to one millimetre.

12. Reactor according to one of Claims 6 to 11, **characterized in that** the first (8) and second (9) heating means consist of a graphite strip or band placed flat, parallel to the lower (37) and upper (38) walls of the duct (6), in a suitable geometry so that, in the deposition zone, the deviations from the mean temperature on that surface of the substrate (10) which is intended for the deposition are less than 3°C.

13. Reactor according to one of Claims 6 to 12, **characterized in that** the first (8) and second (9) heating means are positioned, outside the duct (6) each at a distance of 1 to 3 mm from one of the lower (3 7) or upper (38) walls, respectively.

14. Reactor according to one of Claims 5 to 13, **characterized in that** the first (8) and second (9) heating means may be raised to different temperatures.

15. Reactor according to one of Claims 5 to 14, **characterized in that** the first (8) and second (9) means form only a single heating device placed all around the duct.

16. Reactor according to one of Claims 5 to 15, **characterized in that** the first (8) and second (9) heating means are placed in the region of the deposition zone.

17. Reactor according to one of Claims 8 to 16, **characterized in that** the heating means (8, 9) are supplied with a voltage of less than or equal to 240 volts.

18. Reactor according to one of Claims 5 to 17, **characterized in that** the duct (6) is internally lined, in the hottest parts, continuously with a secondary duct made of refractory material, which is a good thermal conductor and is very stable chemically in relation to the gaseous compounds.

19. Reactor according to one of Claims 5 to 18, **characterized in that** the first (8) and second (9) heating means are offset with respect to each other in the longitudinal direction of the duct (6).

## Patentansprüche

1. Verfahren zur Gasphasenabscheidung von Schichten aus einem Material auf einem sich im wesentlichen in einer Ebene erstreckenden Substrat (10), folgendes umfassend:
- einen Schritt, der darin besteht, das Substrat (10) in einem Kanal (6) anzuordnen, der aus einem feuerfesten Material besteht und von den zum Abscheiden notwendigen Gasmischungen durchströmt wird;
- einen Schritt, der darin besteht, das Substrat (10) zu erhitzen, um einen Temperaturgradienten zu erzeugen, der senkrecht zur Ebene des Substrats (10) und in einer ersten Richtung orientiert ist;
**dadurch gekennzeichnet, daß** der Schritt der Gradientenerzeugung durch das Erhitzen des Substrats durch die Wärmestrahlung des Kanals (6) ausgeführt wird, wobei der Kanal chemisch sehr stabil gegenüber den Gasmischungen und ein guter thermischer Leiter ist und die Strahlung absorbiert, die von ersten und zweiten Heizmitteln abgestrahlt wird, die sich außerhalb des Kanals (6) befinden und aus freiliegenden Widerstandselementen gebildet sind, wobei das Erhitzen des Kanals durch die ersten und zweiten Heizmittel zur Gradientenerzeugung ausgeführt wird, indem die ersten (8) und zweiten (9) Heizmittel unabhängig voneinander mit Strom versorgt werden.

2. Verfahren nach Anspruch 1, **dadurch gekennzeichnet, daß** es einen Schritt umfaßt, der darin besteht, die Richtung des Temperaturgradienten gegenüber der ersten Richtung umzukehren.

3. Verfahren nach Anspruch 1, **dadurch gekennzeichnet, daß** es einen Schritt umfaßt, der darin besteht, wenigstens einen thermischen Schild (14, 15) um die ersten (8) und zweiten (9) Heizmittel herum anzuordnen.

4. Verfahren nach einem der vorhergehenden Ansprüche, **dadurch gekennzeichnet, daß** es einen Schritt umfaßt, der darin besteht, ein Gas umlaufen zu lassen, das neutral ist gegenüber der Gesamtheit der Materialien, die im Reaktor enthalten sind, und gegenüber dem abzuscheidenden Material und den im Kanal (6) strömenden Gasen.

5. Reaktor zur Gasphasenabscheidung von Schichten aus einem Material auf einem sich im wesentlichen in einer Ebene erstreckenden Substrat (10), folgendes umfassend:
- einen Kanal (6) aus einem feuerfesten Material,
- erste (8) und zweite (9) Heizmittel, die sich außerhalb des Kanals (6) auf beiden Seiten der Ebene des Substrats (10) befinden, und
- Mittel (7), um in den Kanal (6) die zum Abscheiden notwendigen Gasmischungen einzubringen,
**dadurch gekennzeichnet, daß**
- die ersten und zweiten Heizmittel aus freiliegenden Widerstandselementen gebildet sind und dafür eingerichtet sind, unabhängig voneinander mit Strom versorgt zu werden, um eine obere und/oder untere Wand des Kanals (6) zu heizen,
- und dadurch, daß der Kanal chemisch sehr stabil gegenüber den Gasmischungen und ein guter thermischer Leiter ist und die Strahlung absorbiert, die von den ersten und zweiten Heizmitteln abgestrahlt wird, wobei das Substrat dafür eingerichtet ist, durch die Wärmestrahlung des Kanals erhitzt zu werden.

6. Reaktor nach Anspruch 5, **dadurch gekennzeichnet, daß** der Kanal (6) einen rechteckigen Querschnitt hat und zwei Platten umfaßt, die eine untere (37) und obere (38) Wand bilden, die horizontal und parallel zur Ebene des Substrats (10) in der Position, die es während der Abscheidung einnimmt, sind.

7. Reaktor nach einem der Ansprüche 5 bis 6, **dadurch gekennzeichnet, daß** er um die ersten (8) und zweiten (9) Heizmittel herum wenigstens einen thermischen Schild (14, 15) umfaßt.

8. Reaktor nach Anspruch 7, **dadurch gekennzeichnet, daß** die gesamte aus dem Kanal (6), den ersten (8) und zweiten (9) Heizmitteln und jedem der thermischen Schilde (14, 15) gebildete Gruppe in einer Röhre (3) plaziert ist.

9. Reaktor nach Anspruch 8, **dadurch gekennzeichnet, daß** der Kanal (6) so in der Röhre (3) gehalten wird, daß er keinen Kontakt mit der Röhre (3) hat.

10. Reaktor nach einem der Ansprüche 8 und 9, **dadurch gekennzeichnet, daß** über den Ausgang des Kanals (6) ein Gasaustausch zwischen dem Innenraum des Kanals (6) und dem Raum, der sich zwischen dem Kanal (6) und der Röhre (3) befindet, ausgeführt werden kann, derart, daß der Druck auf die Wände (37, 38, 39, 40) des Kanals (6) ausgeglichen wird.

11. Reaktor nach Anspruch 10, **dadurch gekennzeichnet, daß** die Dicke der Wände (37, 38, 39, 40) des Kanals (6) kleiner oder gleich ein Millimeter ist.

12. Reaktor nach einem der Ansprüche 6 bis 11, **dadurch gekennzeichnet, daß** die ersten (8) und zweiten (9) Heizmittel aus einem Graphitband oder -streifen gebildet sind, das oder der parallel zur unteren (37) und oberen (38) Wand des Kanals (6) flach angeordnet ist, mit einer Geometrie, die dafür eingerichtet ist, daß in der Abscheidungszone die Abweichungen von der mittleren Temperatur auf der Oberfläche des für die Abscheidung bestimmten Substrats (10) kleiner als 3°C sind.

13. Reaktor nach einem der Ansprüche 6 bis 12, **dadurch gekennzeichnet, daß** die ersten (8) und zweiten (9) Heizmittel außerhalb des Kanals (6) jeweils in einem Abstand von 1 bis 3 mm von einer der unteren (37) oder oberen (38) Wände angeordnet sind.

14. Reaktor nach einem der Ansprüche 5 bis 13, **dadurch gekennzeichnet, daß** die ersten (8) und zweiten (9) Heizmittel auf verschiedene Temperaturen gebracht werden können.

15. Reaktor nach einem der Ansprüche 5 bis 14, **dadurch gekennzeichnet, daß** die ersten (8) und zweiten (9) Heizmittel eine einzige Heizvorrichtung bilden, die ganz um den Kanal herum angeordnet ist.

16. Reaktor nach einem der Ansprüche 5 bis 15, **dadurch gekennzeichnet, daß** die ersten (8) und zweiten (9) Heizmittel im Bereich der Abscheidungszone angeordnet sind.

17. Reaktor nach einem der Ansprüche 8 bis 16, **dadurch gekennzeichnet, daß** die Heizmittel (8, 9) mit einer Spannung versorgt werden, die kleiner oder gleich 240 Volt ist.

18. Reaktor nach einem der Ansprüche 5 bis 17, **dadurch gekennzeichnet, daß** der Kanal (6) in den heißesten Teilen im Inneren verstärkt ist, und zwar auf durchgehende Weise, durch einen sekundären Kanal aus einem Material, das feuerfest, thermisch gut leitend und chemisch sehr stabil gegenüber den Gasmischungen ist.

19. Reaktor nach einem der Ansprüche 5 bis 18, **dadurch gekennzeichnet, daß** die ersten (8) und zweiten (9) Heizmittel in der Längsrichtung des Kanals (6) gegeneinander verschoben sind.
